# EUROPEAN PATENT SPECIFICATION

(11) **EP 0 437 423 B1**
(45) Date of publication and mention of the grant of the patent: **01.09.1993**
(21) Application number: 88908688.0
(22) Date of filing: 05.10.1988
(51) Int. Cl.: G01R 21/00, H02J 7/34

(54) **DC/DC CONVERTER**
GLEICHSTROM/GLEICHSTROM-UMWANDLER
CONVERTISSEUR COURANT CONTINU/COURANT CONTINU

(43) Date of publication of application: 24.07.1991
(73) Proprietor: ROBERT BOSCH GMBH, 70442 Stuttgart (DE)
(72) Inventor: SCHUMACHER, Hartmut, D-7000 Stuttgart 40 (DE); CRISPIN, Norbert, D-7145 Markgröningen (DE); MATTES, Bernhard, D-7123 Sachsenheim (DE)
(74) Representative: Behrens, Ralf Holger, Dipl.-Phys.
(86) International application number: EP8800892
(87) International publication number: WO9004187

(56) References cited:
- EP-A- 0 283 188
- GB-A- 2 006 552
- US-A- 3 851 239
- US-A- 4 739 461

## Description

### State of the Art

The present invention relates to a DC/DC converter of the kind described in the precharacterising part of claim 1, as known from US-A- 4 739 461.

Such a device is already known for use in connection with an air bag protection device in a motor vehicle. The energy store is used for providing energy to control the firing of one or more air bag gas generators for inflating the air bag or bags in the event of loss of battery power during a collision condition and it is advantageous to test the energy storage and conversion capabilities of the DC/DC converter. However, existing systems only determine a minimum energy content or do not periodically test the energy reserves, or they can only test the energy reserve by the use of additional circuitry, which thus leads to additional expense. For example, for testing purposes, the energy reserve is decoupled from the converter by a transistorized stage. Known air bag systems also use integrated switching regulators, or regulate the duty ratio and/or the frequency of the converter by means of an operational amplifier, which lead to an increase in circuitry and expense. However, this provision is inappropriate for air bag systems since regulation to a constant voltage at the output of the converter is not necessary for arbitrary load conditions and input voltages.

It is therefore an object of the present invention to provide a DC/DC converter with minimal circuitry for charging and energy storage, in which the available stored energy and convertability of the converter may be periodically tested to a high degree of accuracy.

### Advantages of the Invention

The aforegoing object is achieved by adopting the feature set forth in the characterising part of claim 1. This has the advantage that the overall function of the entire DC/DC conversion operation can be monitored and assessed as required, since, the following inequality has been established for the particular converter/energy storage capacitor combination, namely, that the minimum output voltage is greater than the maximum battery input voltage.

By means of the features of the sub-claims, a DC/DC converter can be achieved in which a single comparator and constant load provide for the accurate measurement of the time period during which the converter is in its pumping phase, and also the time period in which the energy store discharges through the constant load, as determined by the values of the reference voltage at the comparator. Further, a microprocessor, which may be provided for the aforementioned measurement, may also provide a control signal for switching the converter from a discharging phase to a pumping phase, and then measuring the relevant time parameters of the following complete discharge phase. The measured time values may be used by the microprocessor to calculate the required values of the energy content of the energy store and the efficiency of the converter.

### Drawings

The invention is described further hereinafter, by way of example only, with reference to the accompanying drawings in which:-
Fig. 1 is a circuit diagram of one embodiment of a DC/DC converter in accordance with the present invention; and
Figs. 2a to 2d show the voltage characteristic at different locations of the circuit of Fig. 1 during operation.

### Description of the Exemplary Embodiment

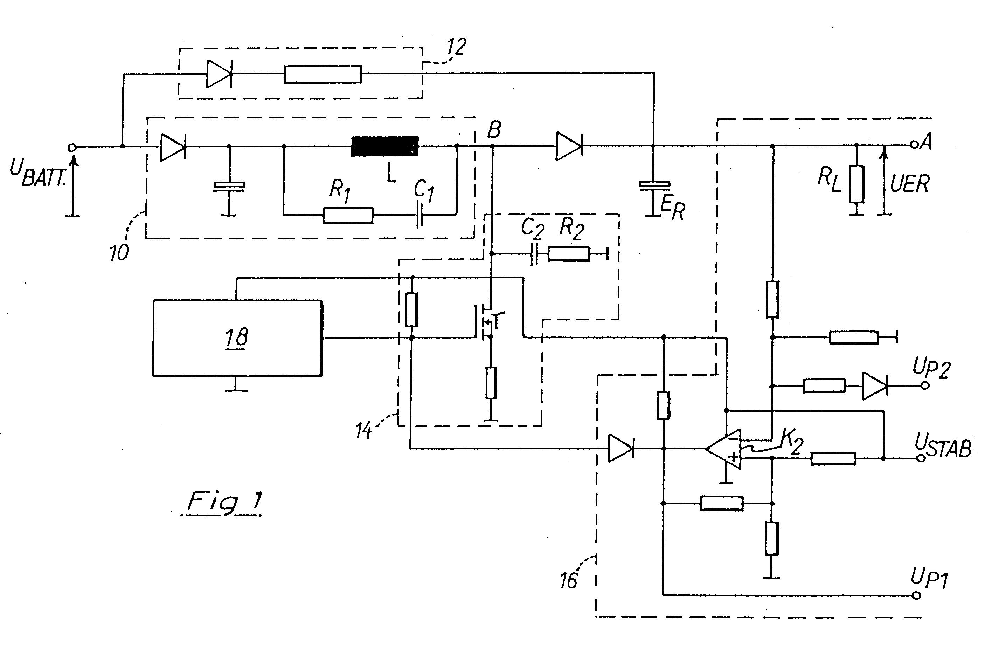

The circuitry of Fig. 1 comprises a DC/DC step up converter, commonly used in connection with an air bag protection device, which operates on the known conversion principle of so-called "flyback regulation" wherein energy is stored in a coil coupled to a DC voltage supply and a higher voltage is generated by periodically shorting the coil to ground by means of a controlled power stage. As illustrated in Fig. 1, the DC voltage supply is provided by a battery voltage U_{BATT} which is supplied to an inductive energy storing device 10 which comprises a coil L in parallel with a "snubber" formed by R₁C₁. The output of the inductive energy storing device 10 is connected at B to a power output stage 14 which comprises a field effect transistor (FET) T and a "snubber" formed by C₂R₂. An astable multivibrator 18 with open collector, periodically supplies a control signal to the gate of the FET T so that point B is periodically connected through the FET T, to ground, as required in accordance with "flyback regulator" operating principle outlined hereinbefore. The increased DC voltage at B charges an energy storage capacitor E_{R}, which may be used to supply the air bag control circuitry via output A, with its desired stepped up voltage in the event of loss of battery power.

The energy storage capacitor E_{R} is also connected to the battery power supply by way of an auxiliary charging circuit 12, commonly provided in safety systems. The circuitry of Fig. 1 further comprises a regulating and monitoring switching circuit 16 included for the purpose of testing the converter and the energy store E_{R}, and which is realized by means of a single comparator K₂.

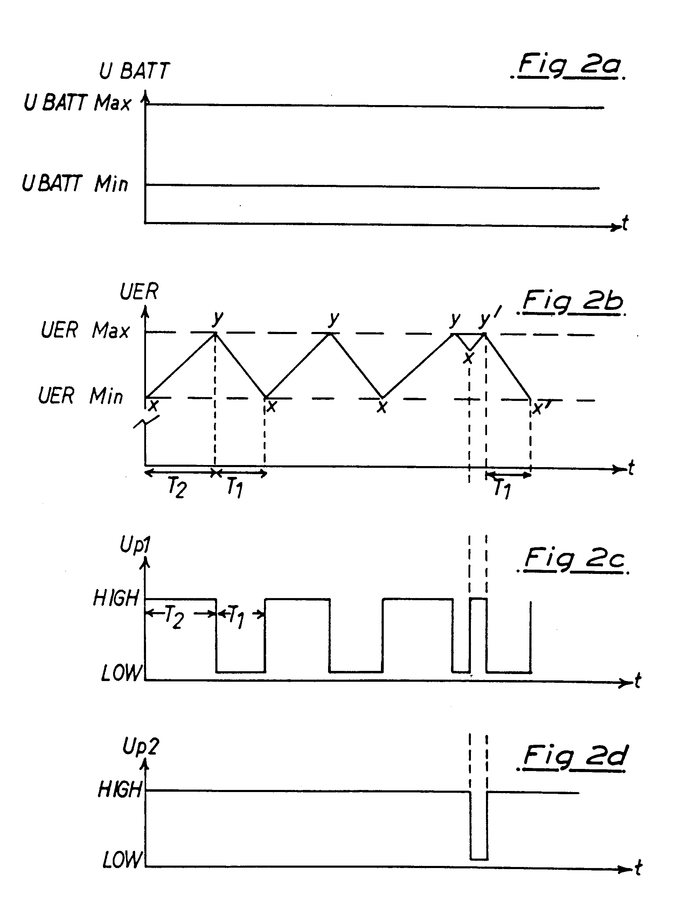

The converter of Fig. 1 operates as follows, with particular reference to the characteristics of Figs. 2a to 2d;
The astable multivibrator 18 operates with a fixed duty ratio and a fixed frequency, and the converter is normally operated in the non-activated range of the overall system, such that, apart from a load represented by R_{L}, no additional load is fed to the control circuitry via output A.

The characteristic of the output voltage U_{ER} across the load R_{L} and apparent at output A is illustrated in Fig. 2b and varies between the limits U_{ER MAX} and U_{ER MIN}. The straight lines of the characteristic of Fig. 2b are intended only to show the principle of the change in output voltage U_{ER} in the time periods T₂ and T₁ (shown in Figs. 2b and 2c), and not the exact characteristic with respect to time.

The converter is in pumping operation when the output voltage U_{ER} is in the range X to Y illustrated in Fig. 2b. As such, the astable multivibrator 18 is periodically providing a control voltage to the gate of T and thus point B is periodically grounded, in accordance with the "flyback regulator" principle. Energy is therefore taken from U_{BATT} and, through intermediate storage in the coil L, is supplied to the energy storage capacitor E_{R}.

In this converter pumping phase, the output U_{P1}, which is derived from the output of the comparator K₂, exhibits a high signal as illustrated in Fig. 2c. The auxiliary charging circuit 12 assists this operation in accordance with the range of the input voltage at U_{BATT}, which range is illustrated in Fig. 2a. For the particular converter/energy store combination, the respective values of U_{ER MIN} and U_{BATT MAX} are established such that U_{ER MIN} > U_{BATT MAX}. As such, it is possible to observe and assess the overall function of the entire DC/DC conversion by means of the regulating and monitoring switching circuit 16. In this manner, a microprocessor associated with the total apparatus, detects the high signal at U_{P1}, and calculates the time period T₂.

By way of example, simple evaluation criterion can then be provided as follows:
T₂ should be smaller than T₂ _{MAX}; and
T₂ _{MAX} is determied for, C_{ER} = C_{ER MAX} and U_{BATT} = U_{BATT MIN}.
In this case, the transition X to Y, lasts the longest (T₂ _{MAX}).

The time period T₁, illustrated in Figs. 2b and 2c, is characterised by the discharge operation of the converter, which operation is established as follows. The comparator K₂ constantly compares the output voltage value U_{ER} with a reference value chosen such that when U_{ER} = U_{ER MAX} the comparator is triggered and its output switched to a low signal, which is apparent at U_{P1}, and, is illustrated in Fig. 2c. This low signal now apparent at the output of the comparator K₂, suppresses the control of the power output stage 14 provided by the astable multivibrator 18, and so prevents point B being connected through to ground and so also prevents the build up of further voltage at point B. The energy stored at E_{R} is discharged by way of the load R_{L}, and the output voltage value U_{ER} falls until it reaches a value U_{ER MIN}, at X (Fig. 2b), at which point the control of the power output stage 14 provided by the astable miltivibrator 18 is re-established, and the converter reverts to its pumping phase.

Since the value of the load R_{L}, or the discharge load current, of the discharge path of the storage capacitor E_{R} is accurately known for the non-activated control unit, namely, when the air bag system has not been activated, the energy content of E_{R}, and also the capacitance of E_{R} can be accurately calcuated from the low phase of the signal at UP₁, by ascertaining T₁. The accuracy of measurement is limited primarily by the tolerance of the stabilized voltage of the total system, for example a tolerance of ±3%.

Since U_{ER MIN} > U_{BATT MAX}, as mentioned hereinbefore, the energy storage capacitor E_{R} is not recharged, by way of the auxiliary charging circuit 12, during the discharge phase of the converter.

The comparator K₂ is such that it enables determination of the limits of the two-state regulation, namely, U_{ER MAX} and U_{ER MIN}, with a high degree of accuracy, and the difference between these values of the output voltage can be as small as 0.5v. The input U_{P2} to the regulating and monitoring switching circuit 16 can be used in synchronizing the monitoring microprocessor of the total system. In order to initiate a discharge phase, Y' to X' (Fig. 2b), a short low pulse, as shown in Fig. 2d, is applied to U_{P2}, while the converter is in its incipient discharge. The short pulse triggers the comparator K₂ which in turn switches the converter into its pumping phase until U_{ER} again reaches U_{ER MAX}, as shown in Fig. 2b. The value of T₁ can then be ascertained as required, and used in calculations performed by the microprocessor.

Thus, for a set range between a minimum and maximum input voltage, the circuitry of the invention produces a set range between a minimum and maximum output voltage. In the normal state, i.e. in the non-activated range of the overall system, the converter acts only on the load R_{L}, or some other defined load, and holds the voltage on the energy storage capacitor within a narrow range of voltage, namely
U_{ER MIN} < U_{ER} desired < U_{ER MAX} for
U_{BATT MIN} < U_{BATT} < U_{BATT MAX}.
When used in energy storage systems, such as air bag systems, three important converter functions can be commonly provided through the use of the single comparator K₂ and the constant load R_{L}.

Firstly, two-state regulation of the output voltage in a narrow range of variation is achieved, while the converter only supplies current to a constant load or well-defined load (R_{L}).

Secondly, exact periodic determination of the stored energy, with respect to time, is achieved by way of the signal obtained at U_{P1} and the microprocessor connected thereto. The ease with which the energy store may be tested is achieved through determining that the values of output voltage of the converter that form the range of variation thereof, are greater than the maximum possible input voltage. By ascertaining an accurate value for the energy stored at any optional input voltage, allows for a specific extraction of energy in the case of activation of the system, i.e. the air bag system.

Thirdly, monitoring of the conversion capability of the converter is achieved and the specifically chosen load R_{L} causes the periodic recharging of the energy store. Monitoring is likewise effected periodically by way of the signal provided at U_{P1}.

The invention is not restricted to the details of the foregoing embodiment. For example, since the converter is operated with a fixed duty ratio and fixed frequency in pump operation, the control module 18 of the FET power switch T₁ can be realised by the wiring of a single comparator as an astable multivibrator. As a further simplification, the astable multivibrator may be omitted and the control signal pulse supplied to the gate of T₁ can be provided by the monitoring microprocessor of the total system. However, the provision of an independent astable miltivibrator enhances the safety and reliability of operation in the case of air bag systems.

## Claims

1. A DC/DC converter, for charging an energy store (E_{R}) connected to earth and including means for testing the energy store and conversion capability of the converter, said DC/DC-converter having an inductive energy storing device (10) which is coupled between a battery voltage and the energy store (E_{R}) and is adapted for periodic grounding by way of a switching stage (14) which switching stage is controlled by a control means (18), so as to generate a charging voltage higher than said battery voltage, the higher voltage charging said energy store (E_{R}), characterised in that said testing means comprises a load (R_{L}) of predetermined resistance connected in parallel to said energy store (E_{R}) and wherein the testing means further comprises a comparator (K₂) having a hysteresis for comparing the voltage across the load (R_{L}) with a reference voltage, and for providing a controlling output to the control of the switching stage (14) whereby the control of the switching stage by the control means (18) may be suppressed, and wherein the output of the comparator (K₂) is connected (U_{P1}) to a microprocessor for determining the respective time periods during which the comparator (K₂) output exhibits its respective output signals.

2. A DC/DC converter according to claim 1, wherein the comparator (K₂) is connected (U_{P2}) to a microprocessor for receiving a short pulse for triggering the comparator (K₂) so as to switch the converter from a discharging phase to a pumping phase.

3. A DC/DC converter according to any of the preceding claims, wherein said control means (18) comprises an astable multivibrator with open collector.

4. A DC/DC converter according to any of the preceding claims, wherein said control means (18) comprises a single comparator.

5. A DC/DC converter according to any of the preceding claims, wherein said control means (18) comprises a microprocessor.

6. A DC/DC converter according to any of the preceding claims, wherein said inductive energy storing device (10) comprises a snubber circuit (R₁, C₁) in parallel with an inductor coil (L).

7. A DC/DC converter according to any of the preceding claims, wherein said switching stage (14) comprises a snubber circuit (R₂, C₂) in parallel with a field effect transistor (T).

8. A DC/DC converter according to any of the preceding claims, wherein said testing means comprises the regulating and monitoring switching circuits (16) of the converter.

## Patentansprüche

1. Gleichstrom/Gleichstrom-Umwandler, für die Aufladung eines mit dem Masseanschluß verbundenen Energiespeichers (E_{R}), umfassend Kontrollmittel für die Überprüfung des Energiespeichers und der Wandlungsfähigkeit des Umwandlers, wobei der Umwandler eine Energiespeichervorrichtung (10) umfaßt, die zwischen der Batteriespannung und dem Energiespeicher (E_{R}) angeordnet ist, und welche vermittels einer von Steuermitteln (18) gesteuerten Schaltstufe periodisch mit Masse verbindbar ist, um auf diese Weise eine die Batteriespannung übersteigende Ladespannung zu erzeugen, wobei die höhere Spannung den erwähnten Energiespeicher (E_{R}) auflädt, dadurch gekennzeichnet, daß die Kontrollmittel einen Lastwiderstand (R_{L}) mit vorgegebenem Widerstandswert umfassen, der parallel zu dem Energiespeicher (E_{R}) geschaltet ist, wobei die Kontrollmittel weiter einen hysteresebehafteten Komparator (K₂) umfassen zum Vergleich der Spannung an dem Lastwiderstand (R_{L}) mit einer Referenzspannung und für die Erzeugung eines Steuerausgangssignals zur Ansteuerung der Schaltstufe (14), wodurch die Ansteuerung der Schaltstufe durch die Steuermittel (18) unterdrückbar ist, und worin der Ausgangsanschluß des Komparators (K₂) mit einem Mikroprozessor verbunden ist (U_{P1}) zur Feststellung der entsprechenden Zeitintervalle, innerhalb derer an dem Ausgangsanschluß des Komparators (K₂) entsprechende Ausgangssignale liegen.

2. Gleichstrom/Gleichstrom-Umwandler nach Anspruch 1, indem der Komparator (K₂) mit einem Mikroprozessor verbunden ist (U_{P2}), um einen kurzen Triggerimpuls zwecks Umschaltung des Umwandlers von seiner Entladephase in eine Pumpphase zu erhalten.

3. Gleichstrom/Gleichstrom-Umwandler nach einem der vorhergehenden Ansprüche, in dem die Steuermittel (18) einen astabilen Multivibrator mit offenem Kollektor umfassen.

4. Gleichstrom/Gleichstrom-Umwandler nach einem der vorhergehenden Ansprüche, in dem die Steuermittel (18) einen einzigen Komparator umfassen.

5. Gleichstrom/Gleichstrom-Umwandler nach einem der vorhergehenden Ansprüche, in dem die Steuermittel (18) einen Mikroprozessor umfassen.

6. Gleichstrom/Gleichstrom-Umwandler nach einem der vorhergehenden Ansprüche, in dem eine induktive Speichereinrichtung (10) einen Freilaufkreis (R₁, C₁) umfaßt, der parallel zu einer Induktivität (L) geschaltet ist.

7. Gleichstrom/Gleichstrom-Umwandler nach einem der vorhergehenden Ansprüche, in dem die Schaltstufe (14) einen Freilaufkreis (R₂, C₂) umfaßt, der parallel zu einem Feldeffekttransistor (T) geschaltet ist.

8. Gleichstrom/Gleichstrom-Umwandler nach einem der vorhergehenden Ansprüche, bei dem die genannten Kontrollmittel die Steuer- und Überwachungsschaltkreise (16) des Umwandlers umfassen.

## Revendications

1. Convertisseur courant continu/courant continu destiné à charger une réserve d'énergie (E_{R}) reliée à la terre, et comprenant des moyens d'essai de la réserve d'énergie et de la capacité de conversion du convertisseur, ce convertisseur courant continu/courant continu comportant un dispositif de stockage d'énergie inductif (10) branché entre une tension de batterie et la réserve d'énergie (E_{R}) et destiné à une mise à la terre périodique par un étage de commutation (14) commandé par un dispositif de commande (18), de manière à générer une tension de charge plus élevée que la tension de batterie, cette tension plus élevée chargeant la réserve d'énergie (E_{R}) ; caractérisé en ce que les moyens d'essai comprennent une charge (R_{L}) de résistance prédéterminée branchée en parallèle sur la réserve d'énergie (E_{R}), en ce que les moyens d'essai comprennent en outre un comparateur (K₂) présentant de l'hystérésis, ce comparateur étant destiné à comparer la tension à travers la charge (R_{L}) à une tension de référence et à fournir un signal de sortie de commande pour commander l'étage de commutation (14) de façon qu'on puisse supprimer la commande de cet étage de commutation par le dispositif de commande (18), et en ce que la sortie du comparateur (K₂) est branchée (en U_{P1}) à un microprocesseur pour déterminer les périodes de temps respectives pendant lesquelles la sortie du comparateur (K₂) présente ses signaux de sortie respectifs.

2. Convertisseur courant continu/courant continu selon la revendication 1, caractérisé en ce que le comparateur (K₂) est branché (en U_{P2}) à un microprocesseur pour recevoir une courte impulsion destinée à déclencher le comparateur (K₂) de manière à commuter le convertisseur d'une phase de décharge à une phase de pompage.

3. Convertisseur courant continu/courant continu selon l'une quelconque des revendications précédentes, caractérisé en ce que le dispositif de commande (18) comprend un multivibrateur astable à collecteur ouvert.

4. Convertisseur courant continu/courant continu selon l'une quelconque des revendications précédentes, caractérisé en ce que le dispositif de commande (18) comprend un comparateur unique.

5. Convertisseur courant continu/courant continu selon l'une quelconque des revendications précédentes, caractérisé en ce que le dispositif de commande (18) comprend un microprocesseur.

6. Convertisseur courant continu/courant continu selon l'une quelconque des revendications précédentes, caractérisé en ce que le dispositif de stockage d'énergie inductif (10) comprend un circuit de reprise (R₁, C₁) en parallèle avec une bobine d'inductance (L).

7. Convertisseur courant continu/courant continu selon l'une quelconque des revendications précédentes, caractérisé en ce que l'étage de commutation (14) comprend un circuit de reprise (R₂, C₂) en parallèle avec un transistor à effet de champ (T).

8. Convertisseur courant continu/courant continu selon l'une quelconque des revendications précédentes, caractérisé en ce que les moyens d'essai comprennent les circuits de commutation de réglage et de surveillance (16) du convertisseur.
